# EUROPEAN PATENT SPECIFICATION

(11) **EP 1 636 598 B1**
(45) Date of publication and mention of the grant of the patent: **01.04.2009**
(21) Application number: 04752375.8
(22) Date of filing: 14.05.2004
(51) Int. Cl.: G01R 19/00

(54) **APPARATUS AND METHOD FOR SENSING EMULATOR CABLE ORIENTATION WHILE PROVIDING SIGNAL DRIVE CAPABILITY**
VORRICHTUNG UND VERFAHREN ZUR ERFASSUNG DER EMULATOR-KABELORIENTIERUNG UNTER BEREITSTELLUNG VON SIGNALANSTEUERFÄHIGKEIT
APPAREIL ET PROCEDE POUR DETECTION D'ORIENTATION D'UN CABLE D'EMULATEUR TOUT EN FOURNISSANT UNE CAPACITE DE COMMANDE DE SIGNAUX

(30) Priority: 23.05.2003 US 473275 P
(43) Date of publication of application: 22.03.2006
(73) Proprietor: Texas Instruments Incorporated, Dallas, Texas 75265-5474 (US)
(72) Inventor: LERNER, Ronald, L., Houston, TX 77079 (US); LARSON, Lee, A., Katy, TX 77491 (US)
(74) Representative: Holt, Michael
(86) International application number: PCT/US2004/015348
(87) International publication number: WO 2004/107103

(56) References cited:
- US-A- 3 600 673
- US-A- 4 130 794
- US-A- 4 277 740
- US-A- 4 399 400
- US-A- 5 170 113
- US-A- 5 187 785
- US-B1- 6 496 014
- US-B1- 6 779 145

## Description

### 1. Field of the Invention

This invention relates generally to the testing of digital signal processing units and, more particularly, to the apparatus facilitating exchange of data between digital signal processing unit under test and the unit receiving the test signals.

### 2. Background of the Invention

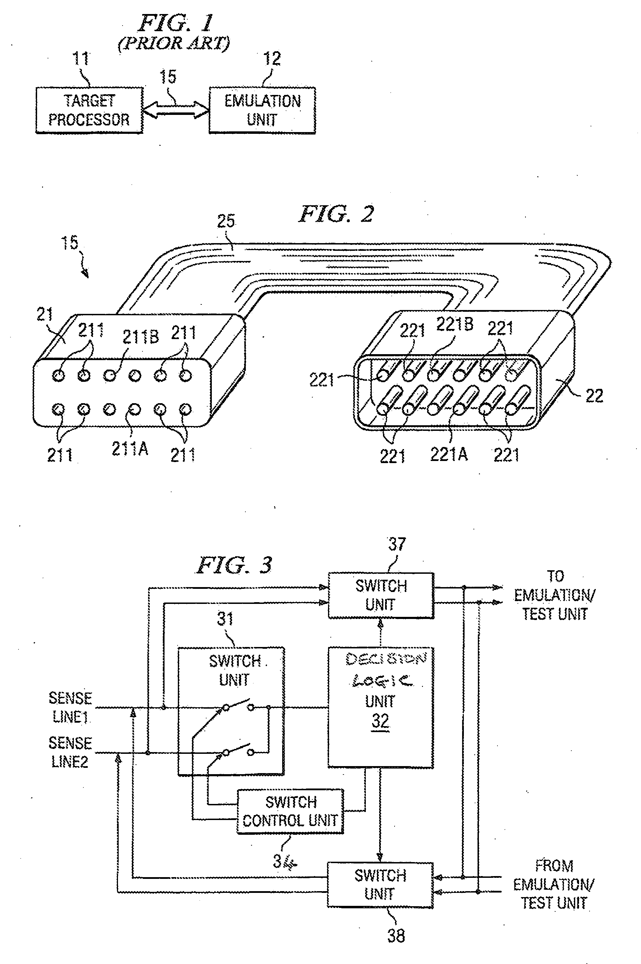

In order to test digital signal processor-based systems, an emulator unit is typically employed. Referring to Fig. 1, a test and debug configuration for testing a target processor **11** using an emulator unit **12** is shown. The target processor **11** is coupled to emulation unit **12** by cable **15.** The test and debug of the target processor **11** is performed under the control of the host processing unit (not shown) that controls the operation of the emulation unit. The host processing unit generates the test and debug commands and analyzes data from the target processor **11.** The emulation unit **12** acts as an interface between the target processor 11 and the host processing unit. The emulation unit **12** will reformat commands from the host processing unit into a format executable by the target processor **11,** while data from the target processor **11** is reformatted into a form that can be processed by the host processing unit. In some embodiments, the emulation unit **12** can be integrated with the host processing unit and included on the same circuit board as the host processing unit.

An emulator cable **15,** according to the prior art, is shown in Fig. 2. The emulator cable **15** includes a conductor cable **25,** a female connector **21,** and a male connector **22.** The conductors of the conductor cable **25** couple each female connector element **211** to a corresponding male connector element **221.** In addition, each female connector **21** and each male connector **22** are symmetric under 180° rotation. In particular, two selected connector elements, **211A** and **211B,** of the female connector 21 and two corresponding connector elements, **221A** and **221B,** of the male connector **22** are selected such that, with a 180° rotation of the two conductors, the two connector elements change position. The connector elements 211A, 211B, 212A, 212B, and the conductors coupling these connector elements are referred to as the sense lines.

Current JTAG (Joint Test Action Group) emulation connectors, with a 14 pin connector element, use a key pin to insure the cable is installed correctly. While effective, it means the key pin cannot be used for any other function. Advanced emulation functions such as trace and high speed RTDX protocols require emulation connectors with more signal pins and more grounds to support the higher signaling rates. Because of the desire for more signal pins and the desire to reduce the footprint of the connector on the user's board, a means of sensing connector element orientation and still providing signal capability is required. The next generation emulation cables will have 60 or more conducting paths. This emulator cable has no keying function so that the user can accidentally install a connector element rotated by 180°. A technique must be provided so that relative rotation of the connector elements is identified and the user is notified without damage to either the target processor **11** or to emulation unit **12.**

It is known in the prior art to provide two conductor terminals, symmetrically located with respect to a 180° rotation of the cable connector, are used to detect the orientation of the emulation unit cable connector relative to the target processor cable connector. Connector elements **211A** and **221A** are labeled sense 1 connectors and connector elements **211B** and **221B** are designated as sense 2 connectors as illustrated in Fig. 2. In the emulation unit **12,** one of the terminals to which sense 1 and sense 2 elements can be coupled is grounded. The target processor determines which sense connector is grounded and can thereby determine the relative orientation of the connectors **21** and **22.** Once the relative orientation of the connectors is determined, the identification of the transmitted signals can be determined.

Because of the large amount of data that is exchanged between the target processor and the emulation unit, it would be desirable to select two sense lines that permit the identification of the relative orientation of the connectors of an emulation cable as well as exchange signals over at least one of the sense lines. It would also be desirable to be able to exchange signals over both of the sense lines. It would be further desirable to characterize the sense lines in a controlled manner. It would also be desirable to characterize the sense lines in terms of impedance and/or voltage. In addition for the JTAG format testing, it would be desirable to identify a terminal in the target processor is typically designated to receive the /TRST signal.

A need has therefore been felt for apparatus and an associated method that would provide a characterization of the sense lines forming the signal paths coupling a target processor and test apparatus. It would be a further feature of the apparatus and associated method to characterize individually the sense lines forming part of the electrical coupling of a test apparatus and a target processor. It would be a still further feature of the apparatus and associated method to provide for transmission of data over at least one of the sense lines. It would be yet a further feature of the apparatus and associated method to specify to which pins in the target processor the sense lines are coupled. It would be a more particular feature of the present invention to be able to identify a particular sense line as receiving a /TRST JTAG signal.

US patent no. 5,170,113 describes a method and apparatus for detecting an improper connection of one or more cables to signal a cable misconnection error. On a board at one end of the cable there is provided a transmit circuit unique to one of the pins or sockets of the connector and at the other end of the cable at an opposite board there is provided a receive circuit that, when the cable is properly connected, receives the signal from the transmit circuit. A misconnection of the cable eliminates the signal from the transmit circuit thus signaling an error at the receive circuit.

### Summary of the Invention

The aforementioned and other features are accomplished, according to the present invention, by selecting two sense lines symmetrical under 180° relative rotation of the cable connectors of an emulator cable. Test apparatus can select a first sense line and provide a characterization of the sense line. The test apparatus can then select the second sense line and characterize the second sense line. The characterization determines the availability of the sense line for exchange of data. In response to control signals generated as a result of the characterization, pre-identified terminals can be coupled to a sense line based on the characterization. In preferred embodiment, the test apparatus can determine the JTAG /TRST terminal.

Other features and advantages of the present invention will be more clearly understood upon reading of the following description and the accompanying drawings and the claims.

### Brief Description of the Drawings

Figure 1 is a block diagram of the components of a test and debug unit according to the prior art.
Figure 2 is a perspective view of an emulator cable according to the prior art.
Figure 3 is a block diagram illustrating the apparatus for determining the relative orientation of emulation cable connectors and the characteristics of the terminals to which terminals are coupled according to the present invention.
Figure 4 is a block diagram illustrating a first implementation for sensing the relative orientation of emulator cable connectors and determination of the characteristics of the terminals coupled to the sense lines according to the present invention.
Figure 5 is a block diagram illustrating a second implementation for sensing the relative orientation of emulator cable connectors and the characteristics of the sense lines coupled thereto according to the present invention.

### Description of the Preferred Embodiment

### 1. Detailed Description of the Figures

Fig. 1 and Fig. 2 have been described with respect to the related art.

Referring now to Fig. 3, a block diagram of the apparatus for determining the characteristics of two sense lines. As indicated above, the two conductor sense lines, SENSE 1 and SENSE 2, are symmetrical with respect to 180° rotation of the cable connectors. The sense lines are applied to the two input terminals of analog switch **31.** The analog switch **31** permits signals to be transmitted in both directions when a switch element is closed. The decision logic unit **32** applies signals to switch control unit **34.** The switch control unit **34** closes a selected one of the switches in the switch unit **31** thereby coupling a selected sense line to the decision logic unit **32.** The decision logic unit **32** determines characteristics of the selected sense line. After the characteristics of the selected sense line have been determined, then the decision logic unit **32** provides signal to the switch control unit **34.** These signals select and couple the second sense line decision logic unit after decoupling the originally selected sense line from decision logic unit **34.** The characteristics of the second sense line are determined by the decision logic unit **32.** Based on the characteristics of the two sense lines, the signals applied to the sense lines and the signals received from the sense lines can be directed in an appropriate manner to the emulator/test unit. The decision logic unit **32** applies ENABLE signals to switch units **37** and **38.** Switch unit **37** determines to which apparatus the signals from the sense lines are directed, while switch unit **38** determines to which of the sense lines the signals from the emulation/test unit are directed. In particular, the /TRST JTAG signal can be directed to the appropriate sense line.

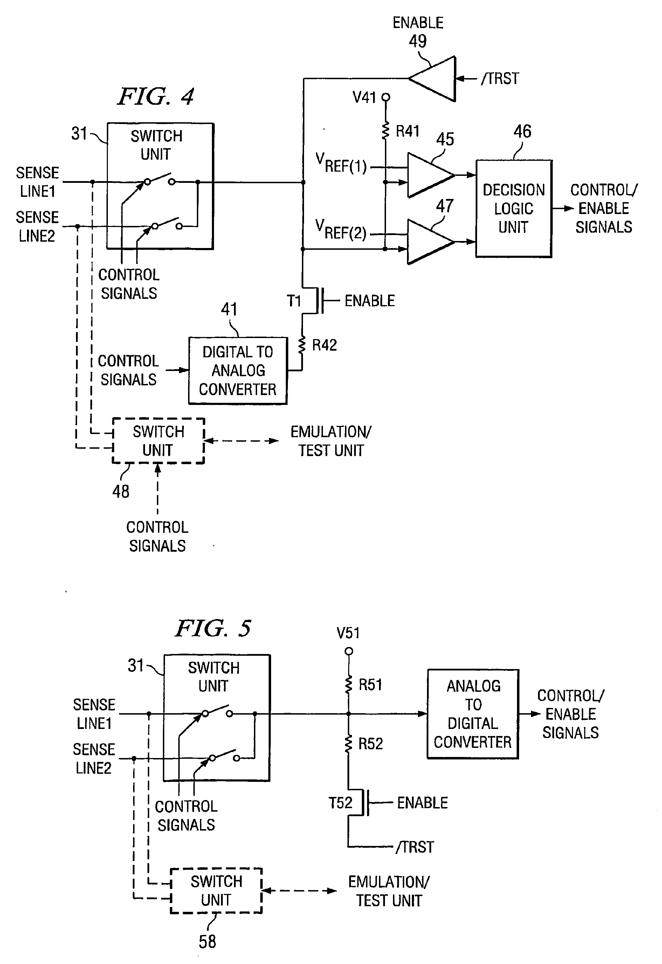

Fig. 4 and Fig. 5 illustrate different configuration for determining the characteristics of the sense line (terminations). Referring to Fig. 4, a determination is made whether a sense line is terminated with a high or a low impedance. In response to control signals, one of the sense lines is coupled to an output terminal of switch unit **31.** The output, terminal of switch unit **31** is coupled through resistor **R41** to voltage source **V41,** is coupled through the serially coupled transistor **T1** and resistor **R42** to digital to analog converter **41,** to an output terminal of analog switch **49,** to a first terminal of comparator **45,** and to a first terminal of comparator **47.** The output terminals of comparator **45** and **47** are applied to decision logic unit **46.** Comparator **45** has a first reference voltage **Vref (1)** to a second terminal thereof, while comparator **47** has a second reference voltage **Vref (2)** applied to a second terminal thereof. Transistor **T1** has an ENABLE signal applied thereto. The selected sense line provides a voltage drop that determines the voltage level applied to the second input terminals of comparators **45** and **47.** The output signals from the comparators **45** and **47** indicate whether the sense line is terminated with a high impedance or with a low impedance. Because the plurality of target processor systems can be used with the emulation system, the parameters of the voltage **V41,** the reference voltages **Vref (1)** and **Vref(2),** and the resistor **R41** are fixed, the output signals of the comparators **45** and **47** may not provide an accurate representation of the relative impedances of the two sense lines. In this event, an enable signal is applied to transistor **T1** and control signals are applied to analog to digital converter **41.** The control signals applied to the analog to digital converter **41** provide an appropriate voltage so that, with respect to **Vref(1)** and the **Vref(2),** appropriate high impedance and low impedance signals are generated at the output terminals of comparators **45** and **47.** The relative values of the resistors **R41** and **R42** are selected so that when the enable signal is applied to transistor **T1,** the voltage level at the output of the digital to analog converter **41** will dominate the signal level generated by the voltage **V41.**

Referring once again to Fig. 4, the output of the analog switch **49** is coupled to the output terminal of switch unit **31.** The analog switch **49** has the /TRST signal applied to an input terminal thereof and an enable signal applied thereto. When the decision logic has identified the appropriate sense line, the decision logic unit applies control signals to the switch unit **31** to insure that the appropriate sense line is coupled to the output terminal of switch unit **31.** The analog switch **49** is enabled (i.e., by the decision logic) and signals can be exchanged over the selected sense line. When signals are to be exchanged over the non-selected sense line, the decision logic applies appropriate control signals to the switch unit **48** so that signals can be exchanged over the non-selected sense line.

Referring next to Fig. 5, a second embodiment for identifying the characteristics of the sense lines is illustrated. In this embodiment, the control unit **32** selects a current sense line. The sense line is coupled to an output terminal of the switch unit **31** by means of control signals applied to switch unit **31.** The output terminal of the switch unit is coupled through resistor **R51** to voltage **V51,** is coupled to an input terminal of analog to digital converter **51** and is coupled through resistor **R52** to transistor **T52.** The output signal of the analog to digital converter **51** is applied to decision logic **56.** The decision logic determines whether the output signal from the analog to digital converter **51** indicates whether the selected sense is a high impedance or a low impedance. When the output from the analog to digital converter does not indicate the selected sense line, then the other sense line is coupled to the output terminal of the switch unit **31.** The decision logic unit **56** determines whether the current sense line is the selected sense line. Or, the decision logic can test the characteristics of both sense lines and then determine which is the selected sense line. The decision logic unit **56,** having determined which sense line is is the selected sense line, couples the selected sense line to the output terminal of the switch unit **31.** An enable signal is then applied to transistor **T52** permitting the /TRST signal to be applied to the selected sense line. When the non-selected sense line is to be used for the transmission of signals, then control signals are applied to the switch unit **58** whereby signals can be exchanged between the target processor and the emulation unit over the non-selected sense line.

### 2. Operation of the Preferred Embodiment

The purpose of the present invention is to identify which of the sense lines can be used for a signal and still provide connector orientation. The sense line is coupled to one of two terminals on the connectors of the emulator cable. The two connectors are located symmetrically with respect to 180° rotation. This symmetry eliminates the need for a key pin, but provides ambiguity with respect to the coupling by the emulator cable to terminals on the target processor and the emulator unit. The present invention permits the relative rotation of the emulation unit connectors to be determined. In particular, in the preferred embodiment, one terminal of the target processor is designated as the terminal to which the /TRST signal is applied. The /TRST terminal is always coupled to one of the two sense lines. The apparatus of the present invention, based on the characteristics of the sense lines, determines to which of the two sense lines the /TRST terminal is coupled. The appropriate sense line can then be coupled to the /TRST signal. In this manner, one of the sense lines can be used to carry a non-optional signal (in the JTAG format).

As will be clear, a protocol will be established with respect to the testing of the sense lines. For example, one of the sense lines can be tested for a predetermined characteristic. When the predetermined characteristic is not present, then the protocol may dictate that the untested sense line has the predetermined characteristic. Or, the protocol may require that the untested sense line be tested to insure that the predetermined characteristic is present. Once the sense line having the predetermined characteristic is identified, then the related signal can be applied to that sense line. And, if appropriate, another signal terminal can be applied to the sense line not having the predetermined characteristic.

While the invention has been described with respect to the embodiments set forth above, the invention is not necessarily limited to these embodiments. Accordingly, other embodiments, variations, and improvements not described herein are not necessarily excluded from the scope of the invention, the scope of the invention being defined by the following claims.

## Claims

1. Sensing apparatus to determine the relative orientation of two cable connectors (21,22), the connector cable (25) coupling a target device (11) and a test device, the two cable connectors coupled to two sense lines (SENSELINE1, SENSELINE2), each sense line comprising a conductor coupled to an equivalently-placed connector terminal of each cable connector (21, 22), the two related connector terminals having 180° rotation symmetry for each cable connector; the target and test device having device connectors for coupling to the cable connectors, a first sense line being coupled to a preestablished impedance, the apparatus comprising:
a switch (31) having a first and a second conductor applied thereto, the switch applying a selected sense line (SENSELINE1, SENSELINE2) to an emulation unit (12) in response to first control signals;
the emulation unit including:
a logic unit (32; '46) for generating control signals; and
a characteristic determination unit, the characteristic determination unit determining a characteristic of the selected sense line, applying the first control signal to the switch when the first sense line has a predetermined characteristic.

2. The apparatus as recited in claim 1 wherein, when the first sense line does not have the predetermined characteristic, the logic unit (32; 46) generates second control signals to the switch (31), the switch in response to the second set of control signals causing the second sense line to be applied to the emulator unit (12), the characteristic determination unit determining the second sense line characteristic.

3. The apparatus as recited in claim 2 wherein the sense line (SENSELINE1, SENSELINE2) having the predetermined characteristic is coupled to the /TRST signal terminal of the target processor (11).

4. The apparatus as recited in claim 2 further comprising a switch (37,38; 48; 58) coupled to the sense lines (SENSELINE1 SENSELINE2), the switch in response to control signals coupling a preselected terminal of the emulation unit (12) to the sense line not having the predetermined characteristic.

5. A method of exchanging data signals between a target processor (11) and an emulation unit (12), the method comprising:
in a cable (15) electrically coupling the target processor and the emulation unit (12) designating two associated terminals (211A,211B, 221A,221B) of each cable connector (21, 22) as sense lines (SENSELINE1 SENSELINE2), the sense lines having a 180° rotational symmetry for each connector;
determining the characteristics for at least one sense line; and
when a sense line (SENSELINE1, SENSELINE2) is determined to have a preselected characteristic, transmitting preselected signals to the target processor (11) over the sense line having the preselected characteristic.

6. The method as recited in claim 5 wherein the preselected characteristic is an imepedance range.

7. The method as recited in claim 5 wherein the preselected characteristic is a voltage level.

8. The method as recited in claim 5 further comprising applying a controllable voltage level to the one sense line.

9. An apparatus according to claim 1, wherein the switch (31) is included in the emulation unit and is responsive to the first control signals for selecting a selected sense line.

10. The apparatus as recited in claim 9 further comprising a switch unit responsive to second control signals from the characteristic determination unit for coupling a sense line having a predetermined characteristic to a first terminal.

11. The apparatus as recited in claims 10 wherein the first terminal has a /TRST JTAG signal applied thereto.

12. The apparatus as recited in claim 9 wherein the characteristic determination unit determines an impedance range.

13. The apparatus as recited in claim 11 wherein the characteristic determination unit includes a controllable voltage unit.

14. The apparatus as recited in claims 9 wherein the characteristic determination unit determines a voltage level.

## Patentansprüche

1. Erfassungsvorrichtung zum Bestimmen der relativen Orientierung von zwei Kabelverbindern (21, 22), wobei das Verbinderkabel (25) eine Zielvorrichtung (11) und eine Testvorrichtung miteinander koppelt, wobei die zwei Kabelverbinder mit zwei Erfassungsleitungen (SENSELINE1, SENSELINE2) gekoppelt sind, wobei jede Erfassungsleitung einen Leiter, der mit einem äquivalent angeordneten Verbinderanschluss jedes Kabelverbinders (21, 22) gekoppelt ist, umfasst, wobei die zwei miteinander in Beziehung stehenden Verbinderanschlüsse für jeden Kabelverbinder eine 180°-Rotationssymmetrie haben; wobei die Ziel- und die Testvorrichtung Vorrichtungsverbinder besitzen, um mit den Kabelverbindern verbunden zu werden, wobei eine erste Erfassungsleitung mit einer im Voraus erstellten Impedanz gekoppelt ist, wobei die Vorrichtung umfasst:
einen Schalter (31) mit einem ersten und einem zweiten Leiter, die damit verbunden sind, wobei der Schalter in Reaktion auf erste Steuersignale eine ausgewählte Erfassungsleitung (SENSELINE1, SENSELINE2) mit einer Emulationseinheit (12) verbindet;
wobei die Emulationseinheit enthält:
eine Logikeinheit (32; 46), um Steuersignale zu erzeugen; und
eine Charakteristik-Bestimmungseinheit, wobei die Charakteristik-Bestimmungseinheit eine Charakteristik der ausgewählten Erfassungsleitung bestimmt und das erste Steuersignal in den Schalter eingibt, wenn die erste Erfassungsleitung eine vorgegebene Charakteristik hat.

2. Vorrichtung nach Anspruch 1, wobei dann, wenn die erste Erfassungsleitung nicht die vorgegebene Charakteristik hat, die Logikeinheit (32; 46) zweite Steuersignale für den Schalter (31) erzeugt, wobei der Schalter in Reaktion auf die zweite Menge von Steuersignalen bewirkt, dass die zweite Erfassungsleitung mit der Emulationseinheit (12) verbunden wird, wobei die Charakteristik-Bestimmungseinheit die Charakteristik der zweiten Erfassungsleitung bestimmt.

3. Vorrichtung nach Anspruch 2, wobei die Erfassungsleitung (SENSELINE1, SENSELINE2), die die vorgegebene Charakteristik hat, mit dem /TRST-Signalanschluss des Zielprozessors (11) gekoppelt ist.

4. Vorrichtung nach Anspruch 2, die ferner einen Schalter (37, 38; 48; 58) umfasst, der mit den Erfassungsleitungen (SENSELINE1, SENSELINE2) gekoppelt ist, wobei der Schalter in Reaktion auf Steuersignale den im Voraus gewählten Anschluss der Emulationseinheit (12) mit jener Erfassungsleitung koppelt, die nicht die vorgegebene Charakteristik besitzt.

5. Verfahren zum Austauschen von Datensignalen zwischen einem Zielprozessor (11) und einer Emulationseinheit (12), wobei das Verfahren umfasst:
in einem Kabel (15), das den Zielprozessor und die Emulationseinheit (12) elektrisch koppelt, Bezeichnen von zwei zugeordneten Anschlüssen (211A, 211B, 221A, 221 B) jedes Kabelverbinders (21, 22) als Erfassungsleitungen (SENSELINE1, SENSELINE2), wobei die Erfassungsleitungen eine 180°-Rotationssymmetrie für jeden Verbinder haben;
Bestimmen der Charakteristiken für wenigstens eine Erfassungsleitung; und
wenn für eine Erfassungsleitung (SENSELINE1, SENSELINE2) bestimmt wird, dass sie eine im Voraus gewählte Charakteristik besitzt, Senden von im Voraus gewählten Signalen zu dem Zielprozessor (11) über die Erfassungsleitung mit der im Voraus gewählten Charakteristik.

6. Verfahren nach Anspruch 5, wobei die im Voraus gewählte Charakteristik ein Impedanzbereich ist.

7. Verfahren nach Anspruch 5, wobei die im Voraus gewählte Charakteristik ein Spannungspegel ist.

8. Verfahren nach Anspruch 5, das ferner das Anlegen eines steuerbaren Spannungspegels an die eine Erfassungsleitung umfasst.

9. Vorrichtung nach Anspruch 1, wobei der Schalter (31) in der Emulationseinheit enthalten ist und auf die ersten Steuersignale anspricht, um eine ausgewählte Erfassungsleitung auszuwählen.

10. Vorrichtung nach Anspruch 9, die ferner eine Schaltereinheit umfasst, die auf zweite Steuersignale von der Charakteristik-Bestimmungseinheit anspricht, um eine Erfassungsleitung mit einer vorgegebenen Charakteristik mit einem ersten Anschluss zu koppeln.

11. Vorrichtung nach Anspruch 10, wobei an den ersten Anschluss ein /TRST JTAG-Signal angelegt wird.

12. Vorrichtung nach Anspruch 9, wobei die Charakteristik-Bestimmungseinheit einen Impedanzbereich bestimmt.

13. Vorrichtung nach Anspruch 11, wobei die Charakteristik-Bestimmungseinheit eine Einheit für steuerbare Spannung enthält.

14. Vorrichtung nach Anspruch 9, wobei die Charakteristik-Bestimmungseinheit einen Spannungspegel bestimmt.

## Revendications

1. Appareil de détection permettant de déterminer l'orientation relative de deux connecteurs de câble (21, 22), le câble de connecteur (25) couplant un dispositif cible (11) et un dispositif de test, les deux connecteurs de câble étant couplés à deux lignes de détection (SENSELINE1, SENSELINE2), chaque ligne de détection comprenant un conducteur couplé à une borne de connecteur placée de façon équivalente de chaque connecteur de câble (21, 22), les deux bornes de connecteur concernées ayant une symétrie de rotation de 180° pour chaque connecteur de câble ; les dispositifs de cible et de test comportant des connecteurs de dispositifs en vue du couplage aux connecteurs de câble, une première ligne de détection étant couplée à une impédance pré-établie, lequel appareil comprend :
- un commutateur (31) auquel sont appliqués un premier et un second conducteurs, le commutateur appliquant une ligne de détection sélectionnée (SENSELINE1, SENSELINE2) à une unité d'émulation (12) en réponse à des premiers signaux de commande ;
- laquelle unité d'émulation comprend :
- une unité logique (32 ; 46) afin de générer des signaux de commande ; et
- une unité de détermination de caractéristique, laquelle unité de détermination de caractéristique détermine une caractéristique de la ligne de détection sélectionnée en appliquant le premier signal de commande au commutateur lorsque la première ligne de détection possède une caractéristique prédéterminée.

2. Appareil tel que décrit dans la revendication 1, dans lequel, lorsque la première ligne de détection ne possède pas la caractéristique prédéterminée, l'unité logique (32 ; 46) génère des seconds signaux de commande vers le commutateur (31), et le commutateur, en réponse au second ensemble de signaux de commande, applique la seconde ligne de détection à l'unité d'émulation (12), l'unité de détermination de caractéristique déterminant la caractéristique de la seconde ligne de détection.

3. Appareil tel que décrit dans la revendication 2, dans lequel la ligne de détection (SENSELINE1, SENSELINE2) possédant la caractéristique prédéterminée est couplée à la borne de signal /TRST du processeur cible (11).

4. Appareil tel que décrit dans la revendication 2, comprenant en outre un commutateur (37, 38 ; 48 ; 58) couplé aux lignes de détection (SENSELINE1, SENSELINE2), lequel commutateur va, en réponse aux signaux de commande, coupler une borne présélectionnée de l'unité d'émulation (12) à la ligne de détection ne possédant pas de caractéristique prédéterminée.

5. Procédé d'échange de signaux de données entre un processeur cible (11) et une unité d'émulation (12), lequel procédé consiste à :
- dans un câble (15), coupler électriquement le processeur cible et l'unité d'émulation (12) désignant deux bornes associées (211A, 211B, 221A, 221B) de chaque connecteur de câble (21, 22) en qualité de lignes de détection (SENSELINE1, SENSELINE2), les lignes de détection ayant une symétrie de rotation de 180° pour chaque connecteur ;
- déterminer les caractéristiques pour au moins une ligne de détection ; et
- lorsqu'il est déterminé qu'une ligne de détection (SENSELINE1, SENSELINE2) possède une caractéristique prédéterminée, transmettre les signaux présélectionnés vers le processeur cible (11) sur la ligne de détection possédant la caractéristique présélectionnée.

6. Procédé tel que décrit dans la revendication 5, dans lequel la caractéristique présélectionnée est une plage d'impédance.

7. Procédé tel que décrit dans la revendication 5, dans lequel la caractéristique présélectionnée est un niveau de tension.

8. Procédé tel que décrit dans la revendication 5, consistant en outre à appliquer un niveau de tension commandable à ladite ligne de détection.

9. Appareil selon la revendication 1, dans lequel le commutateur (31) est compris dans l'unité d'émulation et réagit aux premiers signaux de commande afin de sélectionner une ligne de détection sélectionnée.

10. Appareil tel que décrit dans la revendication 9, comprenant en outre une unité de commutation réagissant aux seconds signaux de commande provenant de l'unité de détermination de caractéristique afin de coupler une ligne de détection possédant une caractéristique prédéterminée à une première borne.

11. Appareil tel que décrit dans la revendication 10, dans lequel un signal /TRST JTAG est appliqué à la première borne.

12. Appareil tel que décrit dans la revendication 9, dans lequel l'unité de détermination de caractéristique détermine une plage d'impédance.

13. Appareil tel que décrit dans la revendication 11, dans lequel l'unité de détermination de caractéristique comprend une unité de tension commandable.

14. Appareil tel que décrit dans la revendication 9, dans lequel l'unité de détermination de caractéristique détermine un niveau de tension.
